# EUROPEAN PATENT APPLICATION

(11) **EP 4 589 306 A1**
(43) Date of publication of application: **23.07.2025**
(21) Application number: 24193802.6
(22) Date of filing: 09.08.2024
(51) Int. Cl.: G01R 1/067, G01R 31/54, G01R 31/69

(54) **ELECTRONIC MEASURING INSTRUMENT**

(30) Priority: 18.01.2024 TW 113101980
(71) Applicant: Power Probe Group, Inc., Charlotte. NC 28216 (US)
(72) Inventor: IP, Foo Wing, Mongkok, Kowloon (HK)
(74) Representative: Clarenbach, Carl-Philipp

(57) **Abstract**

An electronic measuring instrument comprises: an electric meter (1) equipped with a first to fourth holes (11, 12, 13, 14) and a logic circuit, and a meter pen box (2) comprising a circuit board. One end of the meter pen box (2) is equipped with a first to fourth terminals (21, 22, 23, 24). Another end of the meter pen box (2) is equipped with a pair of test probes (25, 26). The first to fourth terminals (21, 22, 23, 24) are correspondingly plugged into the first to fourth holes (11, 12, 13, 14). The circuit board is coupled to the third terminal (23), the fourth terminal (24) and the pair of test probes (25, 26). A metal elastic piece (211) is included in each one of the first terminal (21) and the second terminal (22). A loop between the first hole (11) and the second hole (12) is formed through the meter pen box (2) when the first terminal (21) and the second terminal (22) are plugged into the first hole (11) and the second hole (12) respectively for determining whether the electric meter (1) is plugged with the meter pen box (2) through the logic circuit.

## Description

### TECHNICAL FIELD

The application relates generally to an electronic measuring instrument, and more particularly, to an electronic measuring instrument used for measuring high current.

### BACKGROUND OF THE INVENTION

A multimeter or a clamp-on meter is a multi-purpose electronic measuring instrument, which generally includes many measuring functions such as an ammeter, a voltmeter, an ohmmeter, etc. It is also referred to as a universal meter, a general purpose multitester, a multimeter, etc. Such measuring instrument is mostly inserted with more than one test probe for measurement of various electronic products without limitation of space or place of use.

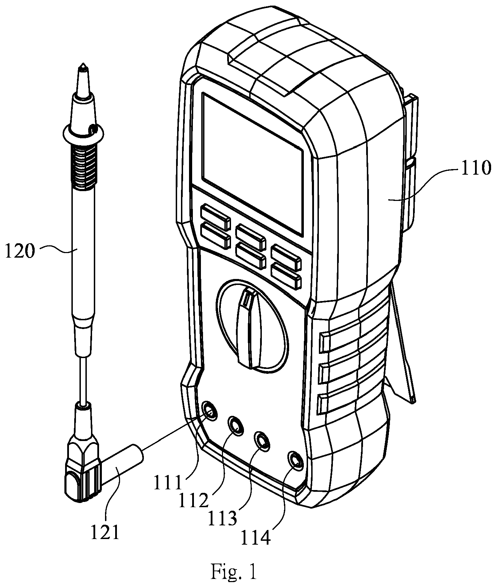

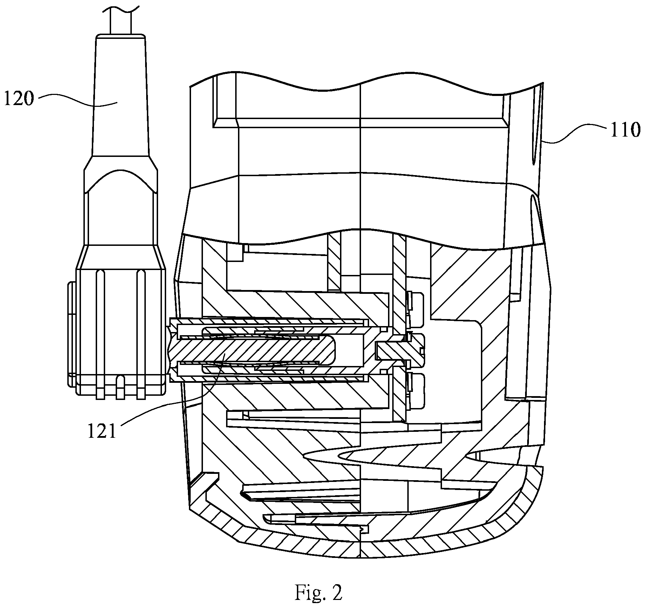

First, referring to FIG. 1, which is a schematic diagram of a conventional multimeter. Main body 110 of multimeter is provided with four holes 111, 112, 113, and 114. At one end of test probe 120, terminal 121 is plugged into hole 111. Another test probe (not shown) is plugged into another hole. When using the multimeter, a measurement of an object to be measured is performed by holding each test probe in both hands. Please referring to FIG. 2, which is a profile of combination of a conventional multimeter and test probe. When terminal 121 of test probe 120 has been plugged into hole 111, complete conduction is formed in the interior between terminal 121 and hole 111.

However, the holes of multimeter as specification components are capable of being used with test probe with universal format in standard measurements. When users perform high current (such as 30A) measurement by test probe with universal format, loop resistance through which current flows across cannot be reduced effectively due to high current measurement design in products and spatial limitation of handheld product itself. Generated heat cannot be dissipated so that causes plastic-deformation of product and unexpected hazards or damages. The above problems should be improved.

### SUMMARY OF THE INVENTION

To address the deficiencies of conventional problem, an embodiment of the invention provides an electronic measuring instrument comprising an electric meter equipped with a first hole, a second hole, a third hole, a fourth hole and a logic circuit, and a meter pen box comprising a circuit board, one end of the meter pen box is equipped with a first terminal, a second terminal, a third terminal and a fourth terminal, another end of the meter pen box is equipped with a pair of test probes, wherein the first to fourth terminal are correspondingly plugged into the first to fourth hole, the circuit board is coupled to the third terminal, the fourth terminal and the pairs of test probes; and wherein a metal elastic piece is included in each one of the first terminal and the second terminal, a loop between the first hole and the second hole is formed through the meter pen box when the first terminal and the second terminal are plugged into the first hole and the second hole respectively for determining whether the electric meter is plugged with the meter pen box through the logic circuit.

In another aspect of the application, the third hole and the fourth hole capturing measuring signals from the pair of test probes for performing measurement of an object to be measured.

In another aspect of the application, the meter pen box comprises a fuse and a current sampling resistor for returning the measuring signal to the electric meter.

In another aspect of the application, the first hole and the second hole are further equipped with a copper-embedded insert, the metal elastic pieces are respectively disposed at sides inside the first terminal and the second terminal, the metal elastic pieces respectively in contact with the copper-embedded inserts when the first terminal and the second terminal are respectively plugged into the first hole and the second hole.

In another aspect of the application, the electric meter further comprises a micro-control unit electrically connected to the logic circuit, measurement mode of the electric meter is determined by the micro-control unit in accordance with relatively high and low relationship between output ends of the logic circuit.

In another aspect of the application, the electric meter further comprises a user interface, an alert message is displayed on the user interface when the measurement mode of the electric meter is determined as an abnormal measurement mode.

In another aspect of the application, the meter pen box is useful for a high current measurement mode in which a maximum measurement current is 30A.

In another aspect of the application, the first hole is a current measurement hole for measuring current under 10A,the second hole is a current measurement hole for measuring current under 1A,the third hole is a grounding terminal, and the fourth hole is a composite measurement hole.

As stated above, this invention provides an electronic measuring instrument with simple structure and high performance. When a high current needs to be measured, a measurement should be performed by an electric meter capable of cooperating with a meter pen box suitable for measurement of high current for avoiding unexpected damage.

### BRIEF DESCRIPTION OF THE DRAWINGS

FIG. 1 is a schematic diagram of a conventional multimeter;
FIG. 2 is a profile of combination of a conventional multimeter and test probe;
FIG. 3 is a schematic diagram of an electronic measuring instrument according to an embodiment of the invention;
FIG. 4 is a profile of meter pen box and electric meter using the meter pen box according to an embodiment of the invention;
FIG. 5 is a side schematic of meter pen box according to an embodiment of the invention.

### DETAILED DESCRIPTION

The making and using of the embodiments of the electronic measuring instrument is discussed in detail below. It should be appreciated, however, that the embodiments provide many applicable inventive concepts that can be embodied in a wide variety of specific contexts. The specific embodiments discussed are merely illustrative of specific ways to make and use the embodiments, and do not limit the scope of the disclosure.

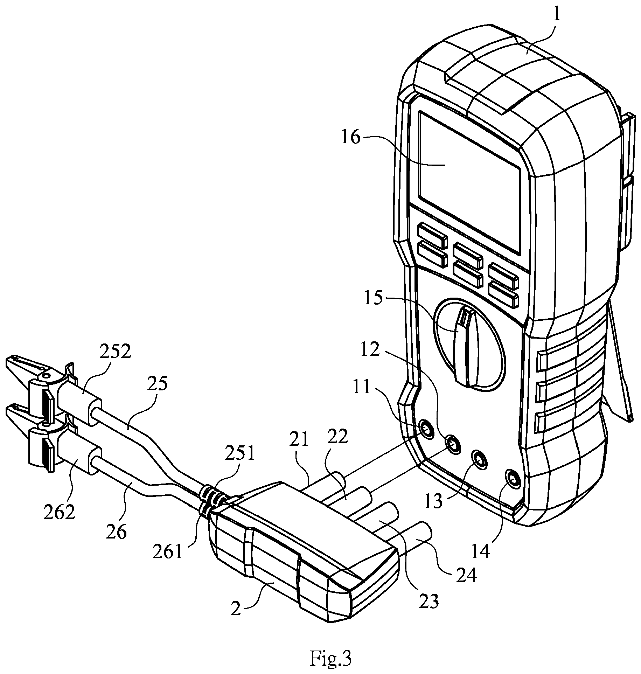

Referring to FIG. 3, FIG. 3 is an appearance schematic of an electronic measuring instrument according to an embodiment of the invention. The electronic measuring instrument of the invention includes an electric meter 1 and a meter pen box 2. The electric meter 1, such as a composite digital electric meter, comprising holes 11, 12, 13 and 14, a knob 15, and a display 16. The knob 15 is used for selecting measurement modes (such as current mode, voltage mode and resistor mode, etc). The display 16 may display measurement result in accordance with measurement mode, etc.

One end of the meter pen box 2 is equipped with four terminals 21, 22, 23 and 24. The terminals 21, 22, 23 and 24 can be plugged into holes 11, 12, 13 and 14 of the electric meter 1 respectively. In this embodiment, the hole 11 is a high current (under 10A) measuring hole, the hole 12 is a small current (under 1A) measuring hole, the hole 13 is a grounding terminal, the hole 14 is a composite measurement (voltage/ resistance/capacitance) hole.

Another end of the meter pen box 2 is connected to a pair of test probes, which is consisted of test probes 25 and 26. A first end 251, 261 of the test probes 25 and 26 are respectively connected to the meter pen box 2. A second end 252, 262 of test probes 25 and 26 are provided for contacting object to perform measurement. The meter pen box 2 including a fuse (current tolerance 30A) and a current sampling resistor (not shown) is used to return measuring signal to the electric meter 1. The hole 13 and hole 14 of the electric meter 1 are used to capture measuring signal from test probes 25 and 26 for performing measurement of the object. The test probes 25 and 26 may be needle type, clipping type or probe type. In this embodiment, the test probes 25 and 26 are crocodile clips.

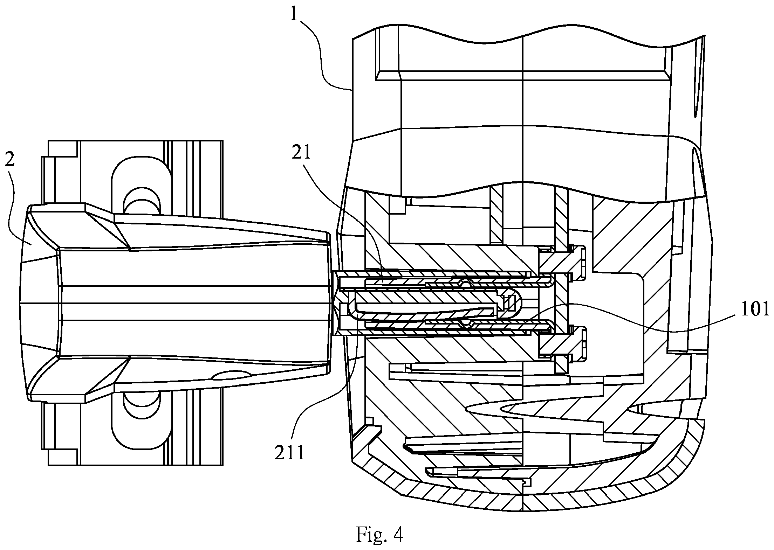

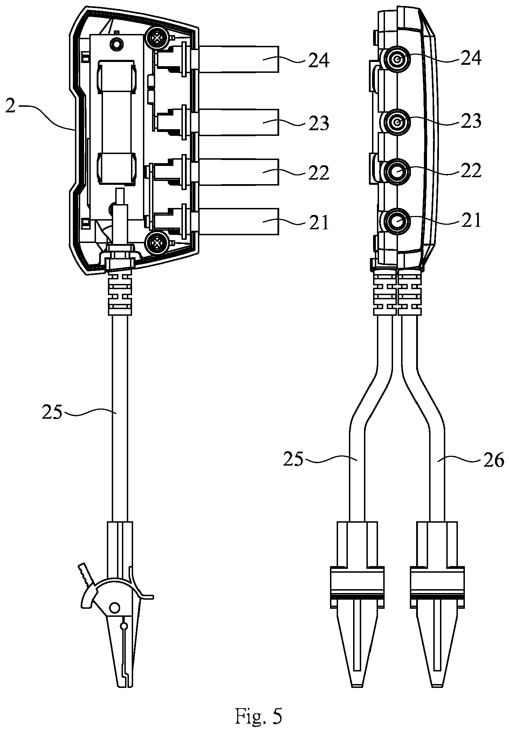

Referring to FIG. 4, FIG. 4 is a profile of a meter pen box and an electric meter using the meter pen box according to an embodiment of the invention. A metal elastic piece 211 is disposed on one side of the terminal 21 in the meter pen box 2 (similarly, a metal elastic piece is also disposed on one side of the terminal 22). Material of the metal elastic piece 211 is preferably a copper. In the hole 11, a copper-embedded inserts 101 are respectively disposed on opposite two sides (similarly, copper-embedded inserts are disposed in the hole 12). FIG. 5 shows side schematic of the meter pen box according to an embodiment of the invention. In this embodiment, the electric meter 1 further includes a logic circuit for detecting current measurement mode, and a micro-control unit (not shown) electrically connected to the logic circuit. The meter pen box 2 further includes a circuit board (not shown). The circuit board is coupled to the terminals 23, 24 and test probes 25, 26. Please referring to FIG. 4 and FIG. 5, when the terminal 21 of the meter pen box 2 is plugged into the hole 11 of the electric meter 1, a single side conduction is formed by the metal elastic piece 211 of the terminal 21 in contact with the copper-embedded insert 101 of hole 11 of the electric meter 1. Similarly, a single side conduction is formed by the copper-embedded insert of hole 12 in contact with the metal elastic piece inside terminal 22, which is plugged into the hole 12. The terminal 21 and terminal 22 are directly shorted-together through a metal (not shown). After the meter pen box 2 plugged into electric meter 1, logic state is changed due to a loop between the holes 11 and 12 formed by the meter pen box 2. Accordingly, whether the electric meter 1 is plugged with the meter pen box 2 is determined by the logic circuit of electric meter 1. In the embodiments of the invention, the meter pen box 2 is suitable for a high current measurement mode with a maximum measurement current as 30A. A measurement for the object may be performed through the test probes 25 and 26.

Further explanation of the above logic circuit is described below. For example, a logic circuit capable of detecting three current measurement modes (mA, A, 30A) is used for detecting in which mode the electric meter should enter. A first to third output end of the logic circuit respectively generates a high level or a low level in different detecting status. As shown in table 1.

**Table 1**

| detecting status | first output end | second output end | third output end | non- current measureme nt screen | current measurem ent screen | note |
|---|---|---|---|---|---|---|
| no test probe plugged | H | L | H | | Alert message 2 | |
| mA test probe plugged | L | L | H | Alert message 1 | | mA mode |
| A test probe plugged | H | H | H | Alert message 1 | | A mode |
| mA and A test probe (non-meter pen box) | L | H | H | Alert message 1 | Alert message 3 | Alert message presence |
| mA and A test probe plugged (meter pen box) | L | H | L | Alert message 1 | | 30Amode |

For example, in the status (no plugged test probe), the first output end level of logic circuit is high level, the second output end level is low level, the third output end level is high level (H is abbreviation of the high level, L is abbreviation of the low level). The above level signals may be returned to a micro-control unit (MCU) of the electric meter so that software determines it is an abnormal measurement mode. At this time, an alert message is shown on a user interface (such as the display 16) for reminding users (for example, Alert message 2: plug into current measurement hole). In different detection states, corresponding alert messages include alert message 1 (plug into voltage measurement hole) and alert message 3 (please do not plug multiple probes). Therefore, in accordance with different levels in each detecting status, coding scheme read by micro-control unit will be generated for determining measurement mode which the current electric meter should enter.

One of features in this invention is to maintain original measurement function and original detection function of the first to fourth holes of electric meter as well as conform to high voltage protection requirements of international safety regulations. Expansion of function can be achieved by adding additional detection function for correctly detecting external expansion component.

While the application has been described by way of example and in terms of preferred embodiment, it should be understood that the application cannot be limited thereto. Those who are skilled in this technology can still make various alterations and modifications without departing from the scope and spirit of this application. Therefore, the scope of the present application shall be defined and protected by the following claims and their equivalents.

## Claims

1. An electronic measuring instrument, comprising:
an electric meter (1) equipped with a first hole (11), a second hole (12), a third hole (13), a fourth hole (14) and a logic circuit; and
a meter pen box (2) comprising a circuit board, one end of the meter pen box(2) is equipped with a first terminal (21), a second terminal (22), a third terminal (23) and a fourth terminal (24), another end of the meter pen box(2) is equipped with a pair of test probes (25, 26),
wherein the first to fourth terminals are correspondingly plugged into the first to fourth holes, the circuit board is coupled to the third terminal (23), the fourth terminal (24) and the pair of test probes (25, 26); and
wherein a metal elastic piece (211) is included in each one of the first terminal (21) and the second terminal (22), a loop between the first hole (11) and the second hole (12) is formed through the meter pen box (2) when the first terminal (21) and the second terminal (22) are plugged into the first hole (11) and the second hole (12) respectively for determining whether the electric meter (1) is plugged with the meter pen box (2) through the logic circuit.

2. The electronic measuring instrument of claim 1, wherein the third hole (13) and the fourth hole (14) capturing measuring signals from the pair of test probes (25, 26) for performing measurement of an object to be measured.

3. The electronic measuring instrument of claim 2, wherein the meter pen box (2) comprises a fuse and a current sampling resistor for returning the measuring signal to the electric meter (1).

4. The electronic measuring instrument of claim 1, wherein the first hole (11) and the second hole (12) are further equipped with a copper-embedded insert (101), the metal elastic pieces (211) are respectively disposed at sides inside the first terminal (21) and the second terminal (22), the metal elastic pieces (211) respectively in contact with the copper-embedded inserts (101) when the first terminal (21) and the second terminal (22) are respectively plugged into the first hole (11) and the second hole (12).

5. The electronic measuring instrument of claim 1, wherein the electric meter (1) further comprises a micro-control unit electrically connected to the logic circuit, measurement mode of the electric meter (1) is determined by the micro-control unit in accordance with relatively high and low relationship between output ends of the logic circuit.

6. The electronic measuring instrument of claim 5, wherein the electric meter (1) further comprises a user interface, an alert message is displayed on the user interface when the measurement mode of the electric meter (1) is determined as a abnormal measurement mode.

7. The electronic measuring instrument of claim 1, wherein the meter pen box (2) is suitable for a high current measurement mode in which a maximum measurement current is 30A.

8. The electronic measuring instrument of claim 1, wherein the first hole (11) is a current measurement hole for measuring current under 10A,the second hole (12) is a current measurement hole for measuring current under 1A,the third hole (13) is a grounding terminal, and the fourth hole (14) is a composite measurement hole.
